# FASCICULE DE BREVET EUROPEEN

(11) **EP 0 545 223 B1**
(45) Date de publication et mention de la délivrance du brevet: **12.06.1996**
(21) Numéro de dépôt: 92119972.5
(22) Date de dépôt: 24.11.1992
(51) Int. Cl.: H05K 7/18

(54) **Bâti d'équipements électroniques, notamment de télécommunications**
Gestell für elektronische Anlage, insbesondere für Vermittlungstechnik
Cabinet for electronic equipment, particularly for telecommunications

(30) Priorité: 29.11.1991 FR 9114858
(43) Date de publication de la demande: 09.06.1993
(73) Titulaire: ALCATEL CIT, F-75008 Paris (FR)
(72) Inventeur: Quelfeter, Guy, F-22300 Ploulec'h (FR); Femenia, René, F-22200 Plouisy (FR); Le Jeune, Denis, F-29210 Morlaix (FR); Verdurand, Rémi, F-92200 Neuilly (FR); Bertin, Claude, F-75013 Paris (FR)
(74) Mandataire: Weinmiller, Jürgen

(56) Documents cités:
- EP-A- 0 057 580
- CH-A- 613 827
- DE-A- 3 731 200

## Description

La présente invention a trait à la construction générale d'un bâti d'équipements électroniques, notamment de télécommunications.

Dans de tels équipements les cartes de circuits imprimés portant les composants électroniques élémentaires et formant ces équipements sont généralement regroupées dans des structures appelées châssis, dans lesquelles elles sont en général disposées verticalement, ces châssis étant à leur tour regroupés dans des structures appelées bâtis dans lesquelles ils sont en général disposés horizontalement .

Ces bâtis sont en outre généralement du type comportant deux montants supportant lesdits châssis, ces montants ayant en outre chacun une forme déterminée pour constituer un volume intérieur creux utilisé pour faire passer des liaisons internes à ce bâti, le long desdits châssis, depuis un point, dit d'entrée, par lequel ces liaisons sont introduites dans ce bâti, et jusqu'à un point, dit de sortie, par lequel elles quittent ce volume pour rejoindre ensuite, transversalement, leur point de destination sur ces châssis, ledit volume intérieur étant en outre ouvert pour permettre un accès auxdites liaisons, par l'une des faces dudit bâti, dite face d'accès, par laquelle il est prévu qu'un opérateur puisse accéder auxdits châssis.

Il ne sera fait état dans la suite de la description que d'un seul montant par bâti et donc d'un seul volume intérieur, mais il est bien évident que le bâti comportant deux montants identiques, présente un second volume intérieur identique et symétrique à celui décrit.

En outre, les points de destination pour un même châssis sont généralement regroupés sur un dispositif appelé bandeau constitué par exemple, au niveau de la partie postérieure du châssis, par un prolongement en hauteur du circuit imprimé de fond de panier sur lequel sont fixés et raccordés les demi-connecteurs nécessaires au raccordement desdits points. La protection mécanique et électromagnétique est assurée par l'adaptation nécessaire de la structure mécanique du châssis au niveau de sa face arrière et de sa face supérieure. Le bandeau ainsi constitué se si tue en retrait vis-à-vis de la face avant du châssis et menage ainsi, entre deux châssis superposés, un volume disponible pour l'accès aux points de sortie et aux connecteurs de raccordement.

Ce type de bâti est par ailleurs généralement de forme sensiblement parallélépipédique, présentant deux faces dites inférieure et supérieure, deux faces dites latérales, et deux faces, dites avant et arrière, l'une de ces deux dernières faces constituant ladite face d'accès, et ledit volume intérieur est également généralement de forme sensiblement parallélépipédique s'inscrivant à l'intérieur du parallélépipéde précédent et ayant par conséquent une hauteur et une profondeur inférieure ou égales à celles de ce dernier, et une largeur très inférieure à celle de ce dernier. On désignera alors respectivement dans ce qui suit par première face celles des faces latérales d'un tel volume intérieur qui est située à l'intérieur dudit bâti, par deuxième face celle des faces, avant ou arrière, d'un tel volume intérieur qui est accessible par ladite face d'accès du bâti, et par troisième et quatrième face respectivement les faces d'un tel volume intérieur qui sont opposées respectivement auxdites première et deuxième face.

La présente invention concerne plus particulièrement le problème de l'accès par un opérateur auxdites liaisons, notamment à celles de ces liaisons qui transportent les signaux à traiter par les équipements de ces bâtis, sur lesquelles on peut en effet être amené à intervenir, en dehors du cas même d'installation de ces équipements, par exemple pour réaliser une modification de câblage de ces liaisons vers lesdits points de destination, ou encore pour remplacer une liaison s'avérant défectueuse. Plus généralement il doit être possible en exploitation de résoudre les problèmes qui se posent sur telle ou telle liaison, sans pour cela perturber ou supprimer ne serait-ce qu'un instant une liaison voisine. Dans ces conditions, il est indispensable que l'exploitant ait un accès facile et individuel à chacun des différents câbles de liaisons d'un bâti.

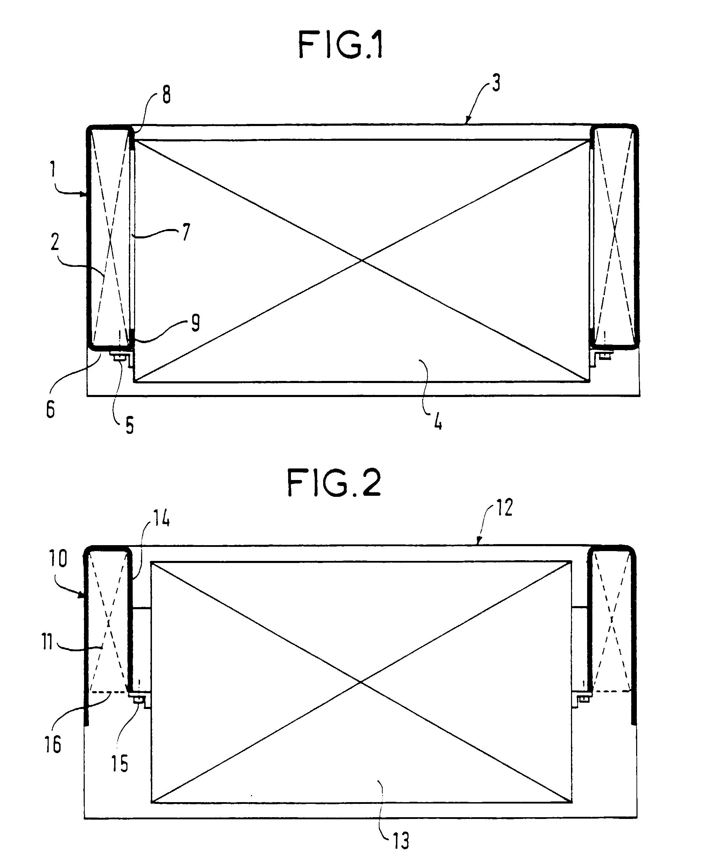

Ce problème est jusqu'à présent généralement résolu de la façon maintenant décrite en relation avec les figures 1 et 2 représentant deux mode de réalisation connus de bâtis du type rappelé ci-dessus.

Un exemple de bâti de ce type est rappelé sur la figure 1, représentant une vue schématique de dessus d'un tel bâti. Dans cet exemple, un montant tel que 1 délimite un volume intérieur tel que 2 symbolisé par une croix en pointillés, et de profondeur voisine de celle du bâti, repéré 3, la différence de profondeur étant utilisée pour réaliser une fixation des châssis, repérés 4, à ces montants, cette fixation, schématisée en 5, étant en effet effectuée par celles des faces de ce volume intérieur, dite deuxième face, et repérée 6.

Ce volume intérieur présente en outre une ouverture occupant, dans le sens de la profondeur, la majeure partie de celles des faces de ce volume intérieur dite première face, ladite ouverture, repérée 7, servant à contenir lesdits points de sortie, et les parties pleines de cette face, repérées 8 et 9, servant à accroître la rigidité de ce montant. Cette forme de montant a pour inconvénient de compliquer beaucoup l'accès d'un opérateur au volume intérieur considéré, et oblige, dans l'hypothèse d'une intervention devant être effectuée sans perturber ou interrompre le fonctionnnement de ces équipements pour les liaisons non concernées par cette intervention, c'est-à-dire en excluant toute éventualité de retrait de châssis destinée à faciliter cet accès, à utiliser maints artifices pour guider ces liaisons tout le long de ce volume intérieur, depuis le point, dit d'entrée, et situé généralement sur l'une des faces, inférieure ou supérieure, de ce volume intérieur, par lequel ces liaisons sont introduites dans le bâti, et jusqu'au point, dit de sortie et situé dans ce cas sur ladite première face, par lequel elles quittent ce volume intérieur pour rejoindre ensuite, transversalement, leur point de destination sur les équipements par l'intermédiaire d'un bandeau comme vu précedemment, ce guidage étant en outre rendu difficile par le fait que ledit volume intérieur est en général de largeur très réduite pour laisser le maximum de place disponible pour les équipements électroniques à l'intérieur du bâti.

Un autre exemple de bâti de ce type est rappelé sur la figure 2, représentant également un tel bâti en vue schématique de dessus (voir aussi le document EP-A-0 057 580).

Dans cet exemple, un montant tel que 10 délimite un volume intérieur tel que 11, également symbolisé par une croix en pointillés, et de profondeur sensiblement égale à la moitié de celle du bâti, repéré 12, les châssis, repérés 13, étant en effet fixés, sensiblement à mi-profondeur du bâti, sur celle des faces de ce volume intérieur, repéré 14 et dite première face, cette fixation étant réalisée par l'intermédiaire d'une pièce entretoise schématisée en 15. Ce volume intérieur présente en outre une ouverture sur celles de ses faces dite deuxième face, repérée 16, cette ouverture servant au passage desdits points de sortie.

L'ensemble des points de destination desdites liaisons étant, dans l'exemple considéré ici d'un accès à l'intérieur du bâti par sa face avant, situé là encore sur un bandeau à l'arrière des châssis, un espace est laissé disponible entre deux châssis superposés. La forme de montant ici utilisé a pour inconvénient d'entraîner plusieurs changements de direction successifs sur le trajet desdites liaisons compris entre leur point de sortie dudit volume intérieur et leur point de destination sur lesdits équipements, avec notamment une partie de ce trajet située perpendiculairement à ladite face d'accès, rendant le rangement de ces liaisons à l'intérieur de ce bâti relativement anarchique et difficile à réaliser sur cette portion de trajet.

La présente invention a pour but de réaliser une structure de bâti pour équipements électroniques, notamment de télécommunications, permettant d'éviter les inconvénients précités.

La présente invention a pour objet un bâti d'équipements électroniques, notamment de télécommunications, du type comportant deux montants supportant lesdits équipements et dont l'un au moins a en outre une forme déterminée pour constituer un volume intérieur creux utilisé pour faire passer des liaisons le long desdits équipements depuis un point, dit d'entrée, par lequel ces liaisons sont introduites dans ce bâti, et jusqu'à un point, dit de sortie, par lequel elles quittent ce volume intérieur pour rejoindre ensuite, transversalement, leur point de destination sur lesdits équipements, ledit volume intérieur étant en outre ouvert pour permettre un accès auxdites liaisons, par l'une des faces dudit bâti, dite face d'accès, par laquelle il est prévu qu'un opérateur puisse accéder auxdits équipements, et ledit bâti étant essentiellement caractérisé en ce que ledit volume intérieur présente d'une part, dans le sens de la hauteur, une ouverture dite première ouverture, accessible par ladite face d'accès, et de hauteur suffisamment importante pour permettre un accès auxdites liaisons sur leur trajet situé le long desdits équipements, et d'autre part, dans le sens de la profondeur, une ouverture, dite deuxième ouverture, également accessible par ladite face d'accès, et servant à contenir lesdits points de sortie.

D'autres objets et caractéristiques de l'invention apparaîtront à la lecture de la description suivante d'un exemple de réalisation, faite en relation avec les dessins ci-annexés dans lesquels, outre les figures 1 et 2 relatives à l'art antérieur et décrites ci-dessus :
- la figure 3 est une vue de dessus d'un bâti d'équipements électroniques suivant l'invention, avec la moitié gauche de la structure prévue à sa face supérieure enlevée,
- la figure 4 est une vue partielle, en perspective éclatée, d'un tel bâti.

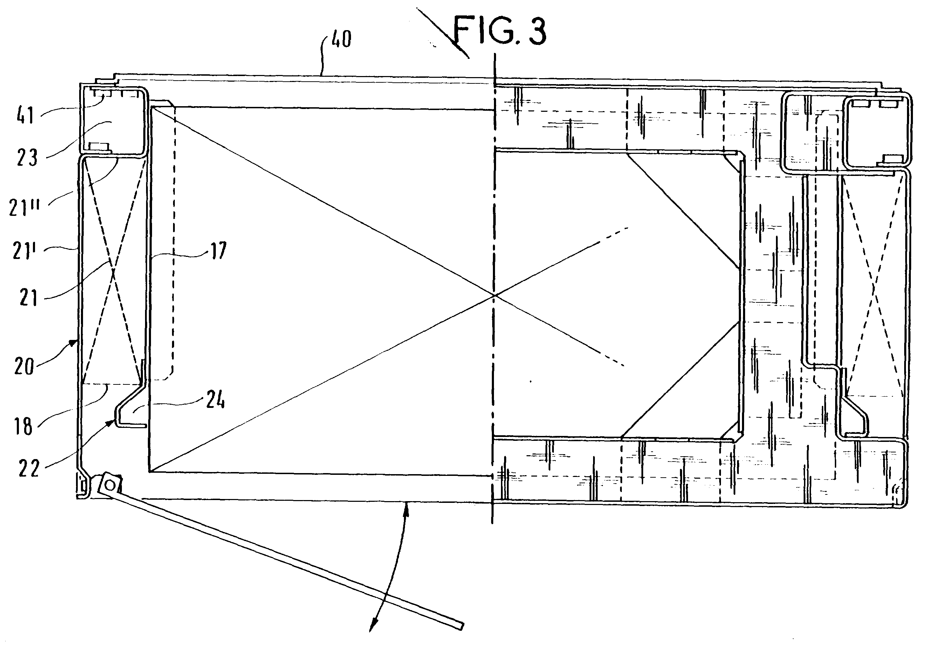

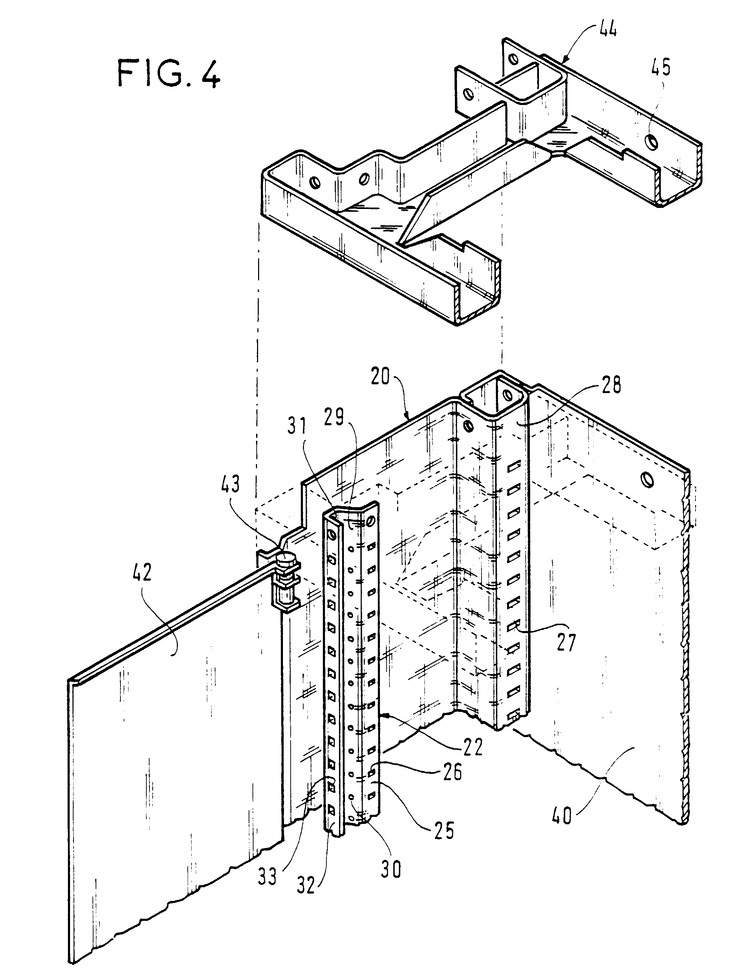

L'exemple de réalisation de l'invention décrit ci-après en relation avec les figures 3 et 4 correspond au cas de bâtis et de volumes intérieurs de forme sensiblement parallélépipédique, pour lequel on utilisera la même convention de désignation des faces que précédemment. Dans cet exemple l'accès à l'intérieur du bâti se fait en outre, également comme considéré jusqu'à présent, par la face avant de ce bâti.

Suivant cet exemple de réalisation, chacun des deux montants du bâti comporte deux profilés :
- un profilé dit extérieur, repéré 20, occupant celles des faces dudit volume intérieur, qui sont dites troisième et quatrième face et qui sont repérées respectivement 21' et 21'', ledit volume intérieur étant repéré 21 et étant symbolisé par une croix en pointillés,
- un profilé dit intérieur, repéré 22, et localisé sensiblement à l'intersection des faces de ce volume intérieur qui sont dites première et deuxième face et qui sont repérées respectivement 17 et 18.

Le volume intérieur 21 présente ainsi, d'une part, dans le sens de la hauteur, sur celle, 18, de ses faces dite deuxième face, une ouverture, accessible par ladite face d'accès, en l'occurence la face avant, et permettant un accès auxdites liaisons, en l'occurence sur la totalité de leur trajet situé le long desdits équipements, et d'autre part, dans le sens de la profondeur, sur celle, 17, de ses faces dite première face, une ouverture également accessible par ladite face d'accès, et servant à contenir lesdits points de sortie, procurant ainsi un accès aisé aux dites liaisons tout le long de leur trajet compris entre lesdits points d'entrée et de sortie de ce volume, en évitant les inconvénients mentionnés dans ce qui précède.

Dans l'exemple de réalisation décrit sur les figures 3 et 4, le profilé extérieur 20 a par ailleurs, à sa partie arrière, au-delà de ladite quatrième face, une forme déterminée par deux pliages consécutifs à angle droit orientés respectivement, le premier vers l'arrière du bâti, le second vers la face latérale concernée dudit bâti, et constitue un autre volume intérieur creux, repéré 23 de section sensiblement carrée, non destiné, ici, à l'inverse de celui repéré 21, à contenir lesdites liaisons, mais dont le contour confére une plus grande rigidité à ce profilé. Eventuellement le volume 23 peut être utilisé pour le passage de câbles tels que des câbles d'alimentation ou autres.

Le profilé intérieur 22 a également une forme déterminée par trois pliages successifs dont l'un à angle droit et les deux autres formant respectivement l'un par rapport à l'autre deux angles obtus alternes-internes et par suite sensiblement égaux, et constitue un autre volume intérieur creux, repéré 24, de section sensiblement trapézoïdale, non destiné ici, à l'inverse de celui repéré 21, à contenir lesdites liaisons, mais dont le contour confére une plus grande rigidité à ce profilé.

Dans cet exemple, ce profilé intérieur présente ainsi successivement :
- une face repérée 25, localisée en l'occurence sur ladite première face du volume intérieur 21, et dans laquelle sont avantageusement percés des trous 26 permettant, par exemple, avec des trous similaires, 27, percés sur celle, 28, des faces du profilé extérieur délimitant le volume intérieur 23, qui est située dans le prolongement de ladite première face, de fixer des réglettes de support desdits châssis, non illustrées expressément sur la figure 4, mais figurées en pointillés sur la figure 3.
- une face repérée 29, orientée dans une direction oblique par rapport à la précédente, et dans laquelle sont avantageusement percés des trous 30 permettant, par exemple, la fixation d'accessoires tels que des éléments de maintien et de rangement desdites liaisons à l'intérieur du volume intérieur 21, non illustrés expressément sur la figure 4,
- une face repérée 31, parallèle à ladite première face,
- une face repérée 32, parallèle à ladite deuxième face, et dans laquelle sont avantageusement percés des trous 33 permettant par exemple une fixation des châssis, non illustrés expressément sur la figure 4, à ce profilé intérieur.

Le bâti représenté sur les figures 3 et 4 comporte par ailleurs, outre les montants ainsi décrits et formant entre autre les faces latérales de ce bâti :
- un panneau arrière 40 fixé en l'occurence par des fixations telles que celle référencée 41, à celle des faces du profilé extérieur délimitant le volume intérieur 23 qui est située parallèlement à ladite quatrième face et sur la face arrière du bâti,
- deux portes avant, telles que celle repérée 42, fixée en l'occurence à un prolongement vers l'avant du profilé extérieur 20, par une fixation telle que celle schématisée en 43,
- une structure d'assemblage de ces divers éléments l'un à l'autre, cette structure comportant une partie inférieure et une partie supérieure qui peuvent être identiques, et qui comportent par exemple, comme illustré pour la partie supérieure 44, une poutre rectangulaire munie de trous tels que 45 pour sa fixation auxdits montants et audit panneau arrière.

## Revendications

1. Bâti d'équipements électroniques, notamment de télécommunications, du type comportant deux montants supportant lesdits équipements, et dont l'un au moins a en outre une forme déterminée pour constituer un volume intérieur creux utilisé pour faire passer des liaisons le long desdits équipements depuis un point, dit d'entrée, par lequel ces liaisons sont introduites dans ce bâti, et jusqu'à un point, dit de sortie, par lequel elles quittent ce volume intérieur pour rejoindre ensuite, transversalement, leur point de destination sur lesdits équipements, ledit volume intérieur étant en outre ouvert pour permettre un accès auxdites liaisons, par l'une des faces dudit bâti, dite face d'accès, par laquelle il est prévu qu'un opérateur puisse accéder auxdits équipements, caractérisé en ce que ledit volume (21) présente d'une part, dans le sens de la hauteur, une ouverture dite première ouverture, accessible par ladite face d'accès, et de hauteur suffisamment importante pour permettre un accès auxdites liaisons sur leur trajet situé le long desdits équipements, et d'autre part, dans le sens de la profondeur, une ouverture, dite deuxième ouverture, également accessible par ladite face d'accès, et servant à contenir lesdits points de sortie.

2. Bâti selon la revendication 1, caractérisé en ce que ledit bâti étant de forme sensiblement parallélépipédique, et présentant notamment deux faces, dites latérales, et deux faces, dites avant et arrière, dont l'une constitue ladite face d'accès, et ledit volume intérieur étant également de forme sensiblement parallélépipédique s'inscrivant à l'intérieur du parallélépipède précédent, ladite première ouverture est localisée sur celle (18), dite deuxième face, des faces avant ou arrière dudit volume intérieur qui est accessible par ladite face d'accès du bâti, et ladite seconde ouverture sur celle (17), dite première face, des faces latérales dudit volume intérieur qui est située à l'intérieur du bâti.

3. Bâti selon la revendication 2, caractérisé en ce que la hauteur desdites ouvertures occupant toute la hauteur des faces correspondantes dudit volume intérieur, lesdits montants comportent, outre un profilé, dit extérieur (20), occupant alors les faces (21', 21") dudit volume intérieur opposées respectivement auxdites première et deuxième face, et dites respectivement troisième et quatrième face, un profilé, dit intérieur (22), localisé sensiblement à l'intersection desdites première et deuxième faces.

4. Bâti selon la revendication 3, caractérisé en ce que lesdits équipements sont fixés audit profilé intérieur (22).

5. Bâti selon l'une des revendications 3 et 4, caractérisé en ce que ledit profilé extérieur a lui-même, au-delà de ladite quatrième face, une forme déterminée pour constituer un autre volume intérieur creux (23).

6. Bâti selon l'une des revendications 3, 4 et 5, caractérisé en ce que ledit profilé intérieur a lui-même une forme déterminée pour constituer un autre volume intérieur creux (24).

7. Bâti selon la revendication 6, caractérisé en ce que ledit profilé intérieur présente plusieurs faces (25, 29, 31, 32) délimitant ledit volume intérieur creux (24) et dans lesquelles sont percés des trous de fixation d'éléments internes audit bâti.

8. Bâti selon la revendication 7, caractérisé en ce que l'une (25) de ces faces est munie de trous (26) de fixation de réglettes de support de châssis d'équipements.

9. Bâti selon la revendication 7, caractérisé en ce que l'une (32) de ces faces est munie de trous (33) de fixation de châssis d'équipements.

10. Bâti selon la revendication 7, caractérisé en ce que l'une (29) de ces faces est munie de trous (30) de fixation d'éléments de rangemnt et de maintien desdites liaisons dans ledit volume intérieur.

## Patentansprüche

1. Gestell für elektronische Einrichtungen, insbesondere für Fernmeldeanlagen, mit zwei diese Einrichtungen tragenden Pfosten, von denen mindestens einer außerdem eine Form hat, die ein hohles Innenvolumen bildet, das für die Verbindungen entlang dieser Einrichtungen von einem Eingangspunkt, durch den diese Verbindungen in dieses Gestell eingeführt werden, bis zu einem Ausgangspunkt bestimmt ist, durch den sie dieses Innenvolumen verlassen, um dann in Querrichtung zu ihrem Bestimmungspunkt in den Einrichtungen zu kommen, wobei das Innenvolumen außerdem offen ist, um einen Zugang für einen Monteur zu den Verbindungen durch eine Zugangsseite des Gestells zu ermöglichen, dadurch gekennzeichnet, daß das Innenvolumen (21) einerseits in Höhenrichtung eine erste von der Zugangsseite her zugängliche Öffnung, deren Höhe groß genug ist, um einen Zugang zu den Verbindungen auf ihrer Strecke entlang der Einrichtungen zu erlauben, und andererseits in Tiefenrichtung eine zweite Öffnung aufweist, die ebenfalls durch die Zugangsseite zugänglich ist und die Ausgangspunkte enthalten soll.

2. Gestell nach Anspruch 1, dadurch gekennzeichnet, daß es im wesentlichen parallelepipedisch ist und zwei Seitenflächen und eine Vorder- und eine Rückseite hat, von denen eine die Zugangsseite bildet, und daß das Innenvolumen ebenfalls im wesentlichen parallelepipedische Form besitzt und sich in das vorhergehende Parallelepiped einfügt, daß sich die erste Öffnung auf der zweiten Seite (18), d.h. der Vorder- oder Rückseite des Innenvolumens, die über die Zugangsseite des Gestells zugänglich ist, befindet, und daß sich die zweite Öffnung auf der ersten Seite (17) der beiden Seitenflächen des Innenvolumens befindet, die sich innerhalb des Gestells befindet.

3. Gestell nach Anspruch 2, dadurch gekennzeichnet, daß die Höhe der Öffnungen die ganze Höhe der entsprechenden Seiten des Innenvolumens einnimmt und die Pfosten außer einem äußeren Profilteil (20), das die dritte und vierte Seite (21', 21") des Innenvolumens einnimmt, die der ersten bzw. der zweiten Seite gegenüberliegen, ein inneres Profilteil (22) aufweisen, das im wesentlichen am Übergang von der ersten zur zweiten Seite angeordnet ist.

4. Gestell nach Anspruch 3, dadurch gekennzeichnet, daß die Einrichtungen am inneren Profilteil (22) befestigt sind.

5. Gestell nach einem der Ansprüche 3 und 4, dadurch gekennzeichnet, daß das äußere Profilteil selbst jenseits der vierten Seite eine bestimmte Form hat, um ein weiteres hohles Innenvolumen (23) zu bilden.

6. Gestell nach einem der Ansprüche 3, 4 und 5, dadurch gekennzeichnet, daß das innere Profilteil seinerseits eine Form hat, die ein weiteres hohles Innenvolumen (24) bildet.

7. Gestell nach Anspruch 6, dadurch gekennzeichnet, daß das innere Profilteil mehrere Seiten (25, 29, 31, 32) aufweist, die das hohle Innenvolumen (24) umgeben und Löcher für die Befestigung von internen Elementen des Gestells aufweisen.

8. Gestell nach Anspruch 7, dadurch gekennzeichnet, daß eine dieser Flächen (25) Löcher (26) für die Befestigung von Stützleisten für die Chassis von Einrichtungen aufweist.

9. Gestell nach Anspruch 7, dadurch gekennzeichnet, daß eine dieser Seiten (32) Löcher (33) für die Befestigung der Chassis der Einrichtungen aufweist.

10. Gestell nach Anspruch 7, dadurch gekennzeichnet, daß eine dieser Seiten (29) Löcher (30) zur Befestigung von Anordnungs- und Halteelementen für die Verbindungen im Innenvolumen aufweist.

## Claims

1. Electronic, especially telecommunication equipment rack comprising two uprights supporting said equipment one at least of which has a shape adapted to constitute a hollow interior volume for passing connections along said equipment from an entry point at which said connections are fed into the rack to an exit point at which they leave said interior volume to run transversely to their respective destination point on said equipment, said interior volume being open to provide access to said connections from an access side of said rack from which there is provision for an operator to access said equipment, characterised in that said volume (21) has a heightwise first opening accessible from said access side and whose height is sufficient to provide access to said connections on their path situated along said equipment and a depthwise second opening also accessible from said access side and adapted to contain said exit points.

2. Rack according to claim 1 characterised in that said rack being of substantially parallelepiped shape having two lateral sides and front and rear sides one of which constitutes said access side, said interior volume being also of substantially parallelepiped shape fitting within the aforementioned parallelepiped, said first opening is on a second lateral side (18) of said front and rear sides of said interior volume which is accessible from said access side of the rack and said second opening is on a first side (17) of said interior volume which is inside the rack.

3. Rack according to claim 2 characterised in that the height of said openings occupies all of the height of the respective sides of said interior volume and said uprights comprise an outer profile (20) occupying third and fourth sides (21', 21") of said interior volume respectively opposite said first and second sides and an inner profile (22) located substantially at the intersection of said first and second sides.

4. Rack according to claim 3 characterised in that said equipment is fixed to said inner profile (22).

5. Rack according to claim 3 or claim 4 characterised in that said outer profile has a shape beyond said fourth side adapted to constitute another hollow interior volume (23).

6. Rack according to any one of claims 3 to 5 characterised in that said inner profile has a shape adapted to constitute another hollow interior volume (24).

7. Rack according to claim 6 characterised in that said inner profile has a plurality of sides (25, 29, 31, 32) delimiting said hollow interior volume (24) in which are formed holes for fixing internal components to said rack.

8. Rack according to claim 7 characterised in that one side (25) is provided with holes (26) for fixing equipment subrack support strips.

9. Rack according to claim 7 characterised in that one side (32) is provided with equipment subrack fixing holes (33).

10. Rack according to claim 7 characterised in that one side (29) is provided with holes (30) for fixing components for locating and retaining said connections in said interior volume.
